# EUROPEAN PATENT APPLICATION

(11) **EP 4 668 566 A1**
(43) Date of publication of application: **24.12.2025**
(21) Application number: 24182801.1
(22) Date of filing: 18.06.2024
(51) Int. Cl.: H02M 7/483, G01R 31/64

(54) **A METHOD OF MONITORING THE CONDITION OF ENERGY STORAGE DEVICE ASSEMBLIES OF A MODULAR MULTI-LEVEL CONVERTER (MMC)**

(71) Applicant: GE Energy Power Conversion Technology Ltd, Rugby, Warwickshire CV21 1BD (GB)
(72) Inventor: Sihler, Christof, 90000 Belfort (FR); Garmier, Pierre-Louis, 90000 Belfort (FR)
(74) Representative: Serjeants LLP

(57) **Abstract**

A method of monitoring the condition of energy storage device assemblies of a modular multi-level converter (MMC) is described. The MMC comprises a plurality of seriesconnected submodules which may have a full-bridge or half-bridge topology, for example. Each submodule include can energy storage device assembly with one or more individual energy storage devices electrically connected in parallel. The MMC further comprises at least one alternating current AC terminal electrically connectable to an AC power source by means of a pre-charge circuit. During two or more pre-charge processes where the individual energy storage device assemblies of the MMC are initially charged to a rated voltage by an AC pre-charge current supplied to the at least one AC terminal from the AC power source, one or more measurements (e.g., vi) of the direct current DC voltage across each energy storage device assembly are obtained at one or more times (e.g., at time ti) between a start and an end of each pre-charge process. The one or more DC voltage measurements obtained during each pre-charge process are compared to determine the health or condition of each energy storage device assembly of the MMC.

## Description

### Technical Field

The present invention relates to modular multi-level converters (MMCs), and in particular a method of simultaneously monitoring the condition of energy storage device assemblies of a MMC using one or more measurements of the DC voltage across each energy storage device assembly during a pre-charge process.

The MMC may comprise a plurality of submodules that are connected together in series to define one or more converter arms of the MMC. Each submodule may comprise an energy storage device assembly with one or more energy storage devices (e.g., one or more parallel-connected capacitors).

### Background Art

Modular multi-level converters (MMCs) are well known for various medium- and high-power applications.

A typical MMC includes at least one converter arm with a plurality of series-connected submodules, and an inductor. The individual submodules can have any suitable topology such as half-bridge or full-bridge, for example, as will be known to the skilled person. Each submodule normally has at least two controllable semiconductor switches, and an energy storage device (e.g., a capacitor). In particular, if each submodule is a half-bridge submodule, it will normally have a leg with two controllable semiconductor switches electrically connected in series. At least one energy storage device is electrically connected in parallel with the series-connected controllable semiconductor switches. If each submodule is a full-bridge submodule, it will normally have a first leg with two controllable semiconductor switches electrically connected in series and a second leg with two controllable semiconductor switches electrically connected in series. The first and second legs are electrically connected in parallel between first and second direct current (DC) submodule rails. An energy storage device (e.g., a capacitor) is electrically connected between the first and second DC rails in parallel with both the first and second legs.

The MMC will typically have a plurality of converter arms. For example, the MMC may include one or more converter arms that are electrically connected in parallel between a pair of DC buses with each converter leg including an upper converter arm with one or more submodules and a lower converter arm with one or more submodules and defining an alternating current (AC) bus therebetween. The MMC may include a plurality of converter arms where each converter arm may be electrically connected at one end to a respective AC bus and electrically connected to each other (e.g., in a star or delta configuration) or to another respective AC bus at the other end.

The MMC will typically have a large number of identical submodules. For example, a MMC with a rated power of 100 MVA or higher might have at least 100 full-bridge submodules or at least 200 half-bridge submodules. In many cases, each submodule may include two or more energy storage devices electrically connected in parallel. Each submodule may therefore have 3-5 individual energy storage devices (e.g., 3-5 parallel-connected capacitors). This means that a MMC will typically have a very large number of energy storage devices. Although defects with modern DC capacitors are rare, individual capacitors will gradually degrade with time and this degradation typically depends on the operating conditions of the MMC, e.g., load cycles, ambient temperature etc. It is not practical to individually test each energy storage device of a MMC. The cost is prohibitive because of the large number of energy storage devices and there is also often limited accessibility depending on where the energy storage devices are located within the converter stack. However, because of the large number of energy storage devices, there is a risk that one or more of the individual energy storage devices will start to degrade earlier than expected, e.g., within the first ten years of operation.

There is therefore a need for a method for reliably determining the condition of the energy storage devices in a MMC.

### Summary of the invention

The present invention provides a method of monitoring the condition of energy storage device assemblies of a modular multi-level converter (MMC), the MMC comprising a plurality of series-connected submodules (e.g., defining a converter arm of the MMC) each submodule comprising a plurality of semiconductor devices, each semiconductor device including at least a controllable semiconductor switch (e.g., an IGBT), and an energy storage device assembly including one or more individual energy storage devices (e.g., one or more individual capacitors) electrically connected in parallel, the MMC further comprising at least one alternating current (AC) terminal electrically connectable to an AC power source, the method comprising:
during a pre-charge process where the individual energy storage device assemblies of the MMC are initially charged to a rated voltage by an AC pre-charge current supplied to the at least one AC terminal from the AC power source, obtaining one or more measurements of the direct current (DC) voltage across each energy storage device assembly at one or more times between a start of the pre-charge process and an end of the pre-charge process; and
using the one or more DC voltage measurements obtained during the pre-charge process to determine the condition of each energy storage device assembly.

In each submodule, each semiconductor device may further include an anti-parallel connected diode, i.e., a diode connected in anti-parallel with its associated controllable semiconductor switch. Controllable semiconductor switches that normally include an anti-parallel connected diode would include insulated-gate bipolar transistors (IGBTs), for example. During the pre-charge process, the energy storage device assembly of each submodule may be charged through the anti-parallel connected diodes and the controllable semiconductor switches are not switched on and off. Because all of the energy storage device assemblies of the submodules are charged simultaneously by an AC-side pre-charge process, they are charged in a series of "steps" - i.e., periods of time when the DC voltage across each energy storage device assembly increases are alternated with periods of time when the DC voltage across each energy storage device assembly remains substantially constant. Such a pre-charge process may also be described as a "pulsed" pre-charge process. However, the overall shape of the DC voltage curve for each energy storage device assembly during pre-charging is substantially exponential. For convenience in the following description the period of time during which the voltage across each energy storage device assembly increases may be referred to as a "charging time period" and the period of time during which the voltage across each energy storage device assembly remains substantially constant may be referred to as a "non-charging time period". Each "step" (or "pulse") comprises a charging time period and a non-charging time period. The transitions between the "steps" (or "pulses") and between the charging and non-charging time periods are regular, well-defined, and will depend on the frequency of the AC pre-charge current that is supplied to the at least one AC terminal of the MMC during the pre-charge process. For example, if the frequency of the supplied AC pre-charge current is 50 Hz, and the submodules are implemented with a full-bridge topology, the duration of each "step" is 10 ms and the duration of each charging and non-charging time period is 5 ms. If the submodules are implemented with a half-bridge topology, the duration of each "step" is 20 ms and the duration of each charging and non-charging time period is 10 ms. If the start of the pre-charge process is accurately determined - see the description below - it is therefore possible to control when the DC voltage across each energy storage device assembly is measured. In particular, it is possible to control DC voltage measurement units of the MMC during pre-charging such that one or more DC voltage measurements are obtained for each energy storage device assembly during one or more of the non-charging time periods. It will be understood that the non-charging time periods are an ideal time for taking DC voltage measurements with minimum variability because the voltage across each energy storage device assembly remains substantially constant. Considering a particular non-charging time period for a particular energy storage device assembly, a single DC voltage measurement may be obtained, or if two or more DC voltage measurements are obtained during the same non-charging time period, an average value of the DC voltage may be determined for that particular non-charging time period. This may improve the reliability of the DC voltage measurements obtained during the pre-charge process. The process of obtaining DC voltage measurements for each energy storage device assembly may be repeated during the pre-charge process, where optionally at least one DC voltage measurement across each energy storage device assembly is obtained during at least some of the non-charging time periods. For example, at least one DC voltage measurement may be obtained for each energy storage device assembly during a selected non-charging time period, or during two or more selected non-charging time periods. If two or more DC voltage measurements are obtained for each selected non-charging time period, an average DC voltage may be determined for each of the selected non-charging time periods. The sampling rate for DC voltage measurements will normally be significantly greater than the duration of each non-charging time period, typically 10 or 20 ms. Consequently, there is normally no difficulty in obtaining several DC voltage measurements during a particular non-charging time period so that an average value may be determined.

The plurality of series-connected submodules may define a converter arm of the MMC. Each converter arm may further comprise at least one inductor. If each converter arm includes at least one inductor it is preferably not bypassed during the pre-charge process. The MMC may comprise a plurality of converter arms, which may be electrically connected together and/or to any external circuit or load in any suitable arrangement as will be known to the skilled person. In particular, the MMC may be utilised for a wide variety of medium- and high-power applications and the converter arms may be configured accordingly for connection to an external power system, including a transmission system or power grid, and/or to an electrical load if the MMC is configured for power conversion. A pair of converter arms may be connected in series to define a converter leg of the MMC and where the converter arms define an AC bus therebetween. The converter arms may be connected together, e.g., in a delta or star configuration, if the MMC is configured as a static synchronous compensator (STATCOM). The MMC may have any suitable overall topology that comprises at least one AC terminal. The MMC may have three AC terminals.

The submodules may have any suitable topology such as half-bridge, full-bridge etc. as will be known to the skilled person. In a half-bridge topology, each submodule comprises a leg with two controllable semiconductor switches electrically connected in series, and the energy storage device assembly is electrically connected in parallel with the series-connected controllable semiconductor switches. In a full-bridge topology, each submodule comprises a first leg with two controllable semiconductor switches electrically connected in series and a second leg with two controllable semiconductor switches electrically connected in series. The first and second legs are electrically connected in parallel between first and second DC rails. The energy storage device assembly is electrically connected between the first and second DC rails in parallel with both the first and second legs.

As noted above, the energy storage device assembly of each submodule may comprise two or more individual energy storage devices electrically connected in parallel, e.g., 3-5 individual parallel-connected capacitors.

Each submodule may include a DC voltage measurement unit (e.g., a voltage sensor) that is adapted to obtain the one or more voltage measurements. Each DC voltage measurement unit may be electrically connected with the energy storage device assembly of the respective submodule. The DC voltage measurements may be sent from each DC voltage measurement unit to a controller (e.g., a converter controller) using any suitable protocol. The controller may store or record the DC voltage measurements and may carry out the processing described in more detail below for monitoring the condition of the energy storage device assemblies. The controller may also send the DC voltage measurements received from each DC voltage measurement unit to a remote server using any suitable protocol, optionally after temporarily storing or recording the DC voltage measurements, but without carrying out any processing. The DC voltage measurements may be sent from each DC voltage measurement unit directly to the remote server. The remote server may store or record the DC voltage measurements and may carry out the processing described in more detail below for monitoring the condition of the energy storage device assemblies. The processing carried out by the controller or remote server may include a calibration or compensation process as described in more detail below. It is typical for each submodule of a MMC to include a DC voltage measurement unit and the present method of condition monitoring does not normally require any modification to the submodule design.

The at least one AC terminal of the MMC may be electrically connected to an AC power source by means of a pre-charge circuit. The AC power source may be a power grid or other supply network, for example. The power grid or other supply network may be a three-phase power grid or supply network. The pre-charge circuit may comprise a pre-charge resistor electrically connected in series to each AC terminal of the MMC. For example, if the MMC comprises three AC terminals, the pre-charge circuit may comprise three pre-charge resistors, each resistor being electrically connected in series to a respective AC terminal of the MMC. Each pre-charge resistor may be bypassed during normal operation of the MMC.

The pre-charge circuit may further comprise a switch, optionally electrically connected between each pre-charge resistor and the AC power source. The pre-charge circuit may comprise three switches, each switch optionally being electrically connected between a respective pre-charge resistor and the AC power source. Each switch may be opened and closed by a controller, for example.

During the pre-charge process, the MMC and the pre-charge circuit may be considered to be a simplified resistor-capacitor circuit (RC circuit).

The start of the pre-charge process may be determined by a close signal that controls the one or more switches of the pre-charge circuit to close, or by measuring the pre-charge current, for example. For example, after the one or more switches have been controlled to close, the start of the pre-charge process may be determined by detecting the first peak of the pre-charge current that is supplied to the pre-charge circuit from the AC power source. Using a measurement of the pre-charge current may often be more accurate than using the close signal or some other determination of when the one or more switches are closed, and may be particularly important if DC voltage measurements obtained during two or more pre-charge processes are to be compared for the purpose of condition monitoring. Any measurement times may then be determined relative to the start time, and this allows DC voltage measurements to be obtained at exactly the same time during different pre-charging processes. For example, the voltage across the energy storage device assemblies may be obtained at exactly x milliseconds after the start time of an initial pre-charge process. During each subsequent pre-charge process, the voltage across the energy storage assemblies may also be obtained at exactly x milliseconds after the start of the respective pre-charge process. The end of the pre-charge process may be determined when the voltage across the energy storage device assemblies has reached a pre-defined value for normal switching operation of the MMC (i.e., the rated voltage). The pre-charge process may typically be completed within a few seconds. After the pre-charging process has been completed, and the energy storage device assemblies are charged to the rated voltage, the MMC may be transitioned to a normal operation where the controllable semiconductor switches of each submodule are switched on and off as required.

At the end of a particular pre-charge process, at least one DC voltage measurement will have been obtained for the energy storage device assembly of each submodule. In practice, it may be that two or more DC voltage measurements will have been obtained for the energy storage device assembly of each submodule as described above. Each DC voltage measurement may relate to a different non-charging time period - e.g., a first DC voltage measurement may be obtained during a first non-charging time period and a second DC voltage measurement may be obtained during a second non-charging time period. Alternatively, two or more DC voltage measurements may relate to the same non-charging time period so as to obtain an average DC voltage for the non-charging time period. It will be readily understood that the DC voltage measurements of all of the energy storage device assemblies are obtained simultaneously during the pre-charge process using only existing "hardware" in the form of the pre-charge circuit and the DC voltage measurement unit of each submodule. This means that the method may be applied to an existing MMC without the need to make any significant modifications to the installed hardware or control software.

The one or more DC voltage measurements for each energy storage device assembly are preferably stored, e.g., in a memory. The stored DC voltage measurements are then processed to determine a condition of each energy storage device assembly. The DC voltage measurements may be processed by the controller or may be sent to a remote server for processing. The processing does not need to be carried out in "real time" but may be done after the pre-charge process has ended and the MMC has started its normal operation.

Condition monitoring may be carried out using the DC voltage measurements obtained from a single pre-charge process. Condition monitoring may also be carried out using the DC voltage measurements obtained from two or more pre-charge processes and where pre-charge processes may be carried out at intervals, e.g., every year, to provide regular monitoring of the condition of the energy storage device assemblies of the MMC over its operating lifetime. In this case, the method may further comprise: during a second pre-charge process where the individual energy storage device assemblies of the MMC are initially charged to a rated voltage by an AC pre-charge current supplied to the at least one AC terminal from the AC power source, obtaining one or more measurements of the DC voltage across each energy storage device assembly at one or more times between a start of the second pre-charge process and an end of the second pre-charge process, and using the one or more DC voltage measurements obtained during the pre-charge process (i.e., an initial pre-charge process) and the one or more DC voltage measurements obtained during the second (or any subsequent) pre-charge process to determine the condition of each energy storage device assembly.

The DC voltage measurements obtained from a single pre-charge process may be used in several different ways to determine the condition of each energy storage device assembly. For example, the DC voltage measurements obtained for each energy storage device assembly at a particular time may be compared. If there are n submodules and hence n energy storage device assemblies (where n is an integer), the DC voltage measurements v₁, v₂, ..., vₙ obtained at the same time (e.g., time t₁) during the pre-charge process, may be compared. (It will be understood that v₁ is the voltage across the energy storage device assembly of a first submodule (e.g., SM₁) measured at time t₁, v₂ is the voltage across the energy storage device assembly of a second submodule (e.g., SM₂) measured at time t₁, and so on, until vₙ is the voltage across the energy storage assembly of an nth submodule (e.g., SMₙ) measured at time t₁.) The time when the DC voltage measurements are obtained may be determined with reference to the start time of the pre-charge process. This ensures that the DC voltage measurements for all of the submodules are obtained at the same time. In one example, the DC voltage measurements v₁, v₂, ..., vₙ obtained at time t₁ may be compared against an expected voltage for the time t₁. (It will be understood that if two or more DC voltage measurements are obtained in quick succession, e.g., during the same non-charging time period, for the purpose of determining an average voltage, the DC voltage measurements may be obtained during a narrow time window and that the start of that time window might correspond to a particular time (e.g., time t₁) for the proper repeatability of multiple DC voltage measurement in different pre-charge processes, for example.) If an individual DC voltage measurement deviates from the expected voltage by more than a pre-defined amount (e.g., by more than ± x%) this may indicate that at least one of the energy storage devices of the particular energy storage device assembly is not in best condition and further testing may be carried out. This may be repeated for DC voltage measurements obtained at later times during the pre-charge process, i.e., DC voltage measurements v₁, v₂, ..., vₙ obtained at time t₂ may be compared against an expected voltage for the time t₂, DC voltage measurements v₁, v₂, ..., vₙ obtained at time t₃ may be compared against an expected voltage for the time t₃, and so on. In another example, the DC voltage measurements v₁, v₂, ..., vₙ obtained at time t₁ may be used to determine an average voltage for the time t₁. If an individual DC voltage measurement deviates from the average voltage by more than a pre-defined amount (e.g., by more than ± x%) this may indicate that at least one of the energy storage devices of the particular energy storage device assembly is not in best condition and further testing may be carried out. This may be repeated for later times during the pre-charge process, i.e., DC voltage measurements v₁, v₂, ..., vₙ obtained at time t₂ may be used to determine an average voltage for the time t₂ and may be compared against the average value for the time t₂, DC voltage measurements v₁, v₂, ..., vₙ obtained at time t₃ may be used to determine an average voltage for the time t₃ and may be compared against the average value for the time t₃, and so on. The times t₁, t₂, t₃ etc. may be selected to correspond to non-charging time periods where the voltage across each energy storage device assembly remains substantially constant during pre-charging. Because of manufacturing tolerances, it may be expected that the measured DC voltages of different energy storage device assemblies at a particular time will vary by up to a few percent even though the individual energy storage devices have exactly the same design and nominal capacitance value. Condition monitoring may here be as simple as categorising any energy storage device assemblies whose DC voltage measurements deviate from the expected or average voltage by less than the predefined amount as having an acceptable condition, and categorising any remaining energy storage device assemblies as requiring further testing or monitoring, for example. Alternatively, the condition monitoring may depend on the amount by which the individual DC voltage measurement deviates from the expected or average voltage, or may use two or more pre-defined amounts that relate to different deviations from the average or expected voltage. For example, if the individual DC voltage measurement deviates from the average or expected voltage by more than a first pre-defined amount (e.g., by more than ± *x1*%) but by less than or equal to a second pre-defined amount (e.g., by less than or equal to ± *x2*% where *x2* is greater than *x1*) this may indicate that at least one of the energy storage devices of the particular energy storage device assembly is not in best condition and further testing may be carried out. However, if the individual DC voltage measurement deviates from the average or expected voltage by more than the second pre-defined amount (e.g., by more than ± *x2*%), this may indicate that more urgent action is needed, including potentially replacing one or more of the energy storage devices of the particular energy storage device assembly. Condition monitoring may be based on any suitable number of pre-defined amounts that allow the deviation of an individual DC voltage measurement of a particular energy storage device assembly from the expected or average voltage to be categorised and if necessary for an appropriate action to be taken depending on the indicated degradation.

It is generally preferred that the condition monitoring uses DC voltage measurements obtained from two or more pre-charge processes. For example, an initial pre-charge process may be carried out to establish a "baseline" for the condition of the energy storage device assemblies. The pre-charge process may then be carried out at intervals, for example every six months, every year, or every two or three years, as part of a regular maintenance program for the MMC, so that the condition of the energy storage device assemblies may be monitored regularly for degradation. For example, if the pre-charge process has been carried out three times, with an initial pre-charge process being carried out in year y₀, a second pre-charge process being carried out a year later in year y₁, and a third pre-charge process being carried out a further year later in year y₂, stored DC voltage measurements for each pre-charge process may be used to determine how the condition of each energy storage device assembly might have changed over time. For example, the DC voltage measurements v₁, v₂, ..., vₙ obtained at time t₁ in year y₁ may be compared against the DC voltage measurements v₁, v₂, ..., vₙ obtained at time t₁ in year y₀. The DC voltage measurements v₁, v₂, ..., vₙ obtained at time t₁ in year y₂ may be compared against the DC voltage measurements v₁, v₂, ..., vₙ obtained at time t₁ in year y₀, and optionally also against the DC voltage measurements v₁, v₂, ..., vₙ obtained at time t₁ in year y₁. The DC voltage measurements for the same energy storage device assembly are compared - in other words, the voltage v₁ of the energy storage device assembly of a first submodule (e.g., SM₁) measured at time t₁ in year y₁ is compared against the voltage v₁ of the energy storage device assembly of the first submodule measured at time t₁ in year y₀, the voltage v₂ of the energy storage device assembly of a second submodule (e.g., SM₂) measured at time t₁ in year y₁ is compared against the voltage v₂ of the energy storage device assembly of the second submodule measured at time t₁ in year y₀, and so on. The time t₁ will be the same for each pre-charge process. In other words, the DC voltage is measured at the same point during the respective pre-charge process as determined from the start of the respective pre-charge process. The same comparison may be carried out for DC voltage measurements obtained at time t₂ in years yₒ and y₁, and so on. This allows the DC voltage measurements obtained for each individual energy storage device assembly at the same time during each pre-charge process (e.g., each year) to be compared directly. Changes in the DC voltage measurements that may indicate the degradation of a particular energy storage device assembly of the MMC may therefore be identified.

The DC voltage measurements obtained for each energy storage device assembly may also be used to determine a characteristic of each energy storage device assembly, which characteristic may then be used to determine the condition of each energy storage device assembly. For example, the determined characteristic may be a time constant of each energy storage device assembly - e.g., the time taken for each energy storage device assembly to charge to 63.2% of its rated voltage. The time constant of each energy storage device assembly is known to be equal to the capacitance of the energy storage device assembly multiplied by the total resistance of the pre-charge circuit. Consequently, any change in the time constant determined in different pre-charge processes is indicative of a change in the capacitance of the particular energy storage device assembly. The total resistance of the pre-charge circuit is the same for all energy storage device assemblies charged at the same time. In one example, the time constants τ₁, τ₂, ..., τₙ determined for a pre-charge process may be compared against an expected time constant. (It will be understood that τ₁ is the time constant of the energy storage device assembly of a first submodule (e.g., SM₁), τ₂ is the time constant of the energy storage device assembly of a second submodule (e.g., SM₂), and so on, until τₙ is the time constant of the energy storage assembly of an nth submodule (e.g., SMₙ).) If an individual time constant deviates from the expected time constant by more than a pre-defined amount (e.g., by more than ± x%) this may indicate that at least one of the energy storage devices of the particular energy storage device assembly is not in best condition and further testing may be carried out. In another example, the time constants τ₁, τ₂, ..., τₙ determined for a pre-charge process may be used to determine an average time constant for the pre-charge process. If an individual time constant deviates from the average time constant by more than a pre-defined amount (e.g., by more than ± x%) this may indicate that at least one of the energy storage devices of the particular energy storage device assembly is not in best condition and further testing may be carried out. Condition monitoring may here be as simple as categorising any energy storage device assemblies whose time constant deviates from the expected or average time constant by less than the predefined amount as having an acceptable condition, and categorising any remaining energy storage device assemblies as requiring further testing or monitoring, for example. Alternatively, the condition monitoring may depend on the amount by which the individual time constant deviates from the expected or average time constant, or may use two or more pre-defined amounts that relate to different deviations from the average or expected time constant. For example, if the individual time constant deviates from the average or expected time constant by more than a first pre-defined amount (e.g., by more than ± x7%) but by less than or equal to a second pre-defined amount (e.g., by less than equal to ± x2% where x2 is greater than *x1*) this may indicate that at least one of the energy storage devices of the particular energy storage device assembly is not in best condition and further testing may be carried out. However, if the individual time constant deviates from the average or expected time constant by more than the second pre-defined amount (e.g., by more than ± x2%), this may indicate that more urgent action is needed, including potentially replacing one or more of the energy storage devices of the particular energy storage device assembly. Condition monitoring may be based on any suitable number of pre-defined amounts that allow the deviation of an individual time constant of a particular energy storage device assembly from the expected or average time constant to be categorised and if necessary for an appropriate action to be taken depending on the indicated degradation.

It is generally preferred that the condition monitoring uses time constants obtained from two or more pre-charge processes as described above. For example, if the pre-charge process has been carried out three times, with an initial pre-charge process being carried out in year y₀, a second pre-charge process being carried out a year later in year y₁, and a third pre-charge process being carried out a further year later in year y₂, stored DC voltage measurements for each pre-charge process may be used to determine how the time constant of each energy storage device assembly might have changed over time. For example, the time constants τ₁, τ₂, ..., τₙ determined in year y₁ may be compared against the time constants τ₁, τ₂, ..., τₙ determined in year y₀. The time constants τ₁, τ₂, ..., τₙ determined in year y₂ may be compared against the time constants τ₁, τ₂, ..., τₙ determined in year y₀, and optionally also against the time constants τ₁, τ₂, ..., τₙ determined in year y₁. The time constants for the same energy storage device assembly are compared - in other words, the time constant τ₁ of the energy storage device assembly of a first submodule (e.g., SM₁) determined in year y₁ is compared against the time constant τ₁ of the energy storage device assembly of the first submodule determined in year y₀, the time constant τ₂ of the energy storage device assembly of a second submodule (e.g., SM₂) determined in year y₁ is compared against the time constant τ₂ for the energy storage device assembly of the second submodule obtained in year y₀, and so on.

Any change in the DC voltage measured across a particular energy storage device assembly at the same time in different pre-charge processes (or any change in the determined time constant or any other capacitance-dependant characteristic of a particular energy storage device assembly) is indicative of a change in the capacitance of the energy storage device assembly. It is important to note that it is not necessary to determine the absolute capacitance of the energy storage device assemblies of the MMC because this would also require knowing other electrical parameters such as the absolute value of the total resistance of the pre-charge circuit, for example. In the above example, if comparison of the respective DC voltage measurements v₁ obtained in years y₁ and y₀ indicates that the DC voltage has decreased by 1% this may be considered to be indicative that the capacitance of the energy storage device assembly of the first submodule (i.e., SM₁) has decreased by 1% over the course of the year. This may not require immediate action, but if the capacitance continues to decrease it may exceed permitted tolerances and the energy storage device assembly may be scheduled for replacement at a suitable point in the future. Further testing may also be carried out to try and identify if only certain of the energy storage devices of the energy storage device assembly are affected. This may avoid the need to replace all of the energy storage devices of the particular submodule. The method may indicate if the capacitance of a particular energy storage device assembly has decreased by more than a threshold amount, where the threshold amount may optionally be determined based on an expected degradation rate of the energy storage devices utilised in the MMC and the period of time between the respective pre-charge processes. As noted above, the measured DC voltages are indicative of the capacitance. For example, the expected degradation rate in the capacitance of the energy storage devices may be 0.5% per year. A decrease of 0.9% in the capacitance (as indicated by the measured DC voltage across a particular energy storage device assembly) would therefore not exceed the threshold amount if the period of time between the respective pre-charge processes was two years, for example. But if the respective pre-charge processes are only one year apart, instead of two years apart, the threshold amount would be exceeded. This is because the capacitance will have decreased by more than 0.5% per year. If the capacitance of an energy storage device assembly decreases by more than about 5%, as compared with the initial capacitance value measured during first commissioning of the MMC, it may have to be replaced. The degradation of modern energy storage devices (e.g., DC capacitors) is normally very slow and may depend on operating conditions (e.g., load cycle conditions, ambient temperature etc.) Under normal operating conditions, degradation of less than 5% is expected during at least ten years of operation. But it may be expected that the normal operating lifetime of the MMC is at least twenty years, which means that regular maintenance checks on the installed DC capacitors is needed, particularly after the first ten years of operation. An on-line (or "real time") method for monitoring the condition of the energy storage device assemblies is not needed, but to meet customer expectations and improve the availability of the MMC by scheduling preventative maintenance and replacement of degraded energy storage devices, the present method provides a simple, automated, and reliable way of monitoring the condition of the energy storage device assemblies when carrying out an AC-side pre-charge process. The present method will typically have less than 0.2% tolerance in repeatability by obtaining DC voltage measurements in an automated way and by always using the same pre-charge circuit and other components, e.g., the same DC voltage measurement units. The times when DC voltages are measured by the DC voltage measurement unit of each submodule can be carefully controlled based on a detected start of each pre-charge process. This ensures that DC voltage measurements are obtained at exactly the same time in different pre-charge processes - i.e., that the times t₁, t₂, t₃ mentioned in the above examples are the same for each pre-charging of the MMC. This also ensures that DC voltage measurements are only obtained during non-charging time periods if appropriate.

It will be understood that there may be some variation in electrical parameters when the pre-charge process is carried out at different times, e.g., each year. Although the same pre-charge circuit with the same pre-charge resistors will be used for each pre-charging of the MMC, there may still be some variation in the absolute value of the total resistance of the pre-charge circuit as a result of differences in ambient temperature, for example. There may also be some variation in the AC pre-charge current supplied by the AC power source, particularly if the AC power source is a power grid, for example. However, such variations may be considered to affect the DC voltage measurements for each energy storage device assembly in the same way and can therefore be corrected or compensated for using a suitable calibration or compensation process. For example, because the total resistance of the pre-charge circuit is the same for all energy storage device assemblies charged at the same time, any variation in the total resistance when each pre-charge process is carried out will have the same effect on the DC voltages measured across all of the energy storage device assemblies. In other words, the disturbances to be eliminated by the calibration or compensation process are "common mode" disturbances. A calibration or compensation process may be carried out on the stored DC voltage measurements obtained during a pre-charge process before any comparison is made with the stored DC voltage measurements obtained during a previous pre-charge process. Any suitable calibration or compensation process may be used.

The calibrated or compensated DC voltage measurements obtained after carrying out the calibration or compensation process may also be stored and may then be used in any comparison made with DC voltage measurements obtained in a subsequent pre-charge process.

The present invention further provides a MMC comprising:
a plurality of series-connected submodules, each submodule comprising:
   a plurality of semiconductor devices, each semiconductor device including at least a controllable semiconductor switch, and
   an energy storage device assembly including one or more individual energy storage devices electrically connected in parallel;
at least one AC terminal electrically connectable to an AC power source; and
a condition monitoring device adapted to:
   obtain one or more measurements of the DC voltage across each energy storage device assembly at one or more times between a start of a pre-charge process and an end of the pre-charge process, wherein during the pre-charge process the individual energy storage device assemblies of the MMC are initially charged to a rated voltage by an AC pre-charge current supplied to the at least one AC terminal from the AC power source; and
   use the one or more DC voltage measurements obtained during the pre-charge process to determine the condition of each energy storage device assembly.

Further technical features of the MMC may be as described above.

The condition monitoring device may comprise the controller and/or the remote server described above. If each submodule further comprises a DC voltage measurement unit (e.g., a voltage sensor), the condition monitoring device may further comprise the DC voltage measurement units. The DC voltage measurement units are adapted to obtain the one or more voltage measurements. Each DC voltage measurement unit may be electrically connected with the energy storage device assembly of the respective submodule. The DC voltage measurements may be sent from each DC voltage measurement unit using any suitable protocol.

### Drawings

Figure 1 shows a first example of a modular multi-level converter (MMC) according to the present invention implemented as a variable speed drive (VSD);
Figures 2 and 3 show a second and third examples of a MMC according to the present invention implemented as a static synchronous compensator (STATCOM);
Figure 4 shows a first example of a converter arm for a MMC with a plurality of series-connected submodules having a half-bridge topology;
Figure 5 shows a second example of a converter arm for a MMC with a plurality of series-connected submodules having a full-bridge topology;
Figure 6 shows a pre-charge circuit that may be used for pre-charging a MMC;
Figure 7 shows a DC voltage curve for a capacitor assembly of a MMC during a pre-charging process;
Figure 8 shows part of the DC voltage curve of Figure 7;
Figure 9 shows DC voltage curves for a plurality of capacitor assemblies of a MMC during a pre-charging process; and
Figure 10 shows DC voltage curves for a capacitor assembly of a MMC during different pre-charging processes.

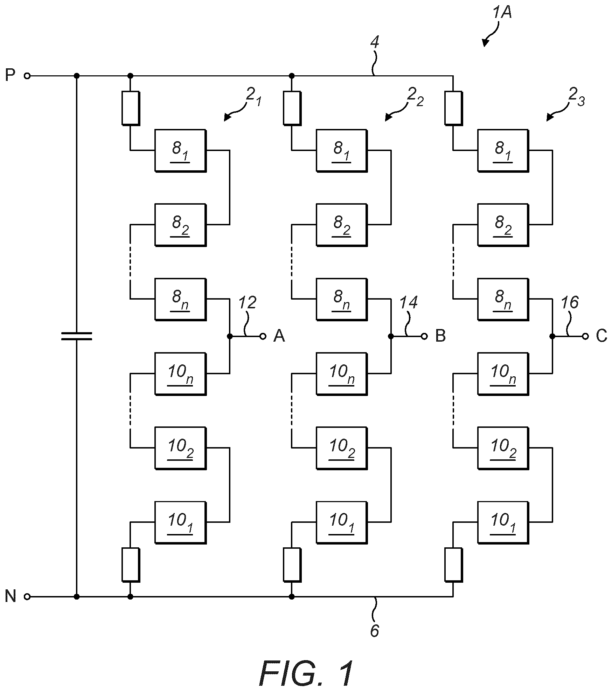

Figure 1 shows a first example of a modular multi-level converter (MMC) 1A implemented as a variable speed drive (VSD).

The MMC 1A includes three converter legs 2₁, 2₂ and 2₃ connected in parallel between first and second direct current (DC) buses 4, 6. Each converter leg 2₁, 2₂, and 2₃ is divided into an upper converter arm and a lower converter arm. Each upper converter arm includes n series-connected submodules 8₁, 8₂, ..., 8ₙ and each lower converter arm includes n series-connected submodules 10₁, 10₂, ..., 10ₙ, where n is any suitable integer. Each converter arm includes an inductor.

The connection between the upper converter arm and the lower converter arm of the first converter leg 2₁ defines a first alternating current (AC) bus 12. The connection between the upper converter arm and the lower converter arm of the second converter leg 2₂ defines a second AC bus 14. The connection between the upper converter arm and the lower converter arm of the third converter leg 2₃ defines a third AC bus 16. The first, second and third AC buses 12, 14 and 16 each define a respective AC phase (labelled "A", "B" and "C") and can be connected to a three-phase AC load or a three-phase AC supply. The first and second DC buses 4 and 6 can be connected to a DC load or a DC supply and can include a DC link with one or more energy storage devices (e.g., DC link capacitors).

The MMC 1A can convert a DC input voltage to an AC output voltage or *vice versa* by operating the submodules 8₁, 8₂, ..., 8ₙ and 10₁, 10₂, ..., 10ₙ of the first, second and third converter legs 2₁, 2₂ and 2₃ in a manner well known to the skilled person.

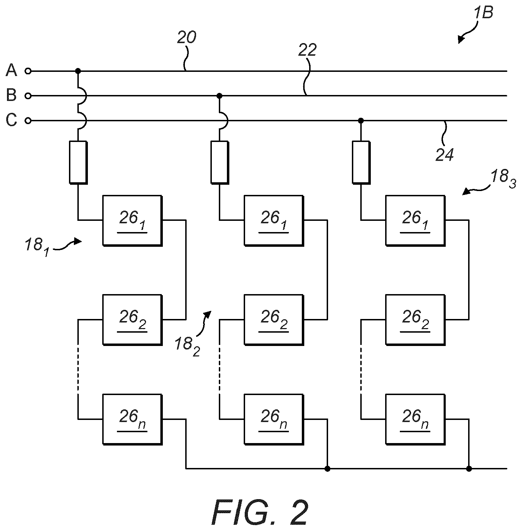

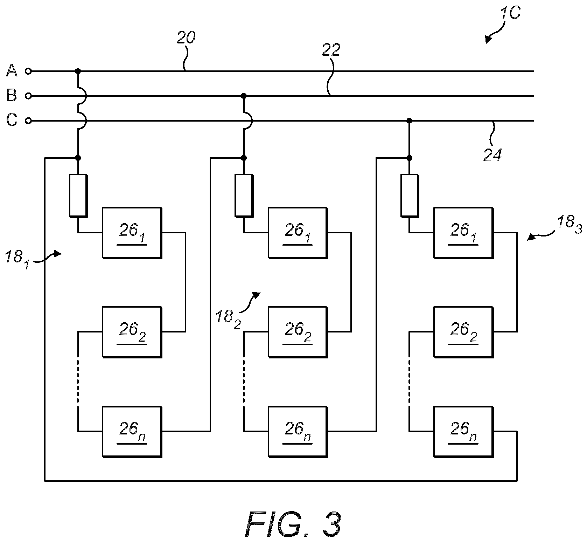

Figures 2 and 3 show second and third examples of a MMC 1B and 1C implemented as a static synchronous compensator (STATCOM).

Each MMC 1B and 1C includes three converter arms 18₁, 18₂ and 18₃. The first converter arm 18₁ is connected to a first AC bus 20 at a first end. The second converter arm 18₂ is connected to a second AC bus 22 at a first end. The third converter arm 18₃ is connected to a third AC bus 24 at a first end. The first, second and third AC buses 20, 22 and 24 each define a respective AC phase (labelled "A", "B" and "C"). In the MMC 1B shown in Figure 2, the first, second and third converter arms 18₁, 18₂ and 18₃ are connected together in a star configuration at their second ends. In the MMC 1C shown in Figure 3, the first, second and third converter arms 18₁, 18₂ and 18₃ are connected together in a delta configuration at this second ends.

Each converter arm 18₁, 18₂ and 18₃ includes n series-connected submodules 26₁, 26₂, ..., 26ₙ, where n is any suitable integer. Each converter arm 18₁, 18₂ and 18₃ includes an inductor.

By operating the submodules 26₁, 26₂, ..., 26ₙ of the first, second and third converter arms 18₁, 18₂ and 18₃, the MMC 1B and 1C can act as a source or sink of reactive AC power for regulating an AC transmission network, for example.

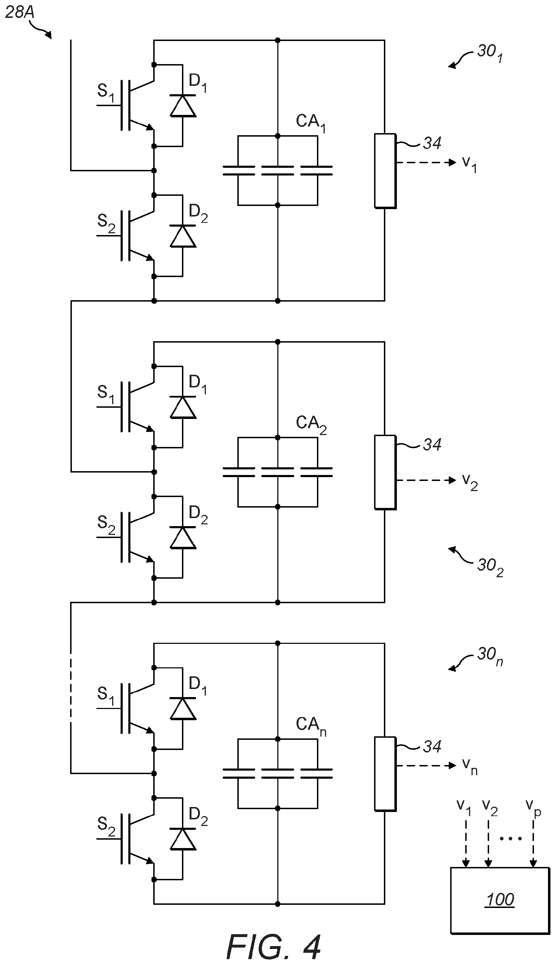

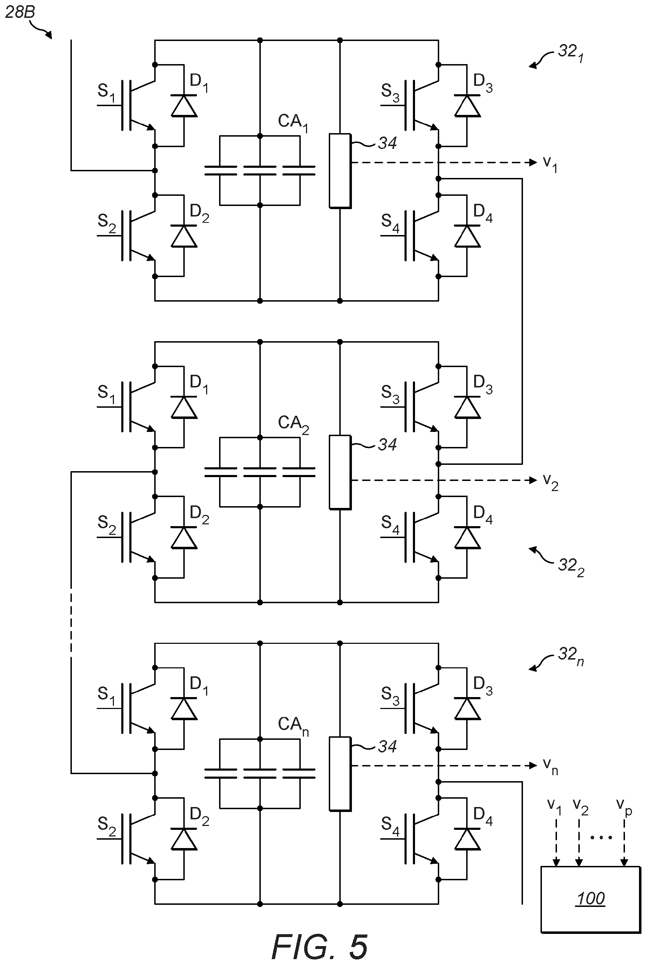

Figures 4 and 5 respectively show first and second examples of converter arms 28A and 28B. The converter arm 28A includes n series-connected submodules 30₁, 30₂, ..., 30ₙ, where n is any suitable integer. Similarly, the converter arm 28B includes n series-connected submodules 32₁, 32₂, ..., 32ₙ, where n is any suitable integer. The converter arms 28A and 28B may be utilised as one of the converter arms of the MMC 1A shown in Figure 1, or one of the converter arms of the MMC 1B or 1C shown in Figures 2 and 3, respectively.

The submodules 30₁, 30₂, ..., 30ₙ in Figure 4 are shown as having a half-bridge topology. In the half-bridge topology, each submodule 30₁, 30₂, ..., 30ₙ comprises a leg with two controllable semiconductor switches S₁ and S₂ electrically connected in series. Each semiconductor switch is shown as an IGBT with an anti-parallel connected diode D₁ and D₂, but it will be readily understood that other controllable semiconductor switches can be used. Each submodule 30₁, 30₂, ..., 30ₙ comprises three energy storage devices (i.e., three capacitors) that are electrically connected in parallel with the series-connected semiconductor switches S₁ and S₂. The three capacitors form a capacitor assembly CA of the respective submodule. Although three capacitors are shown, it will be understood each capacitor assembly CA₁, CA₂, ..., CAₙ may have any suitable number of parallel-connected capacitors.

The submodules 32₁, 32₂, ..., 32ₙ in Figure 5 are shown as having a full-bridge topology. In the full-bridge topology, each submodule 32₁, 32₂, ..., 32ₙ comprises a first leg with two controllable semiconductor switches S₁ and S₂ connected in series and a second leg with two controllable semiconductor switches S₃ and S₄ connected in series. Each semiconductor switch is shown as an IGBT with an anti-parallel connected diode D₁, D₂, ..., D₄, but it will be readily understood that other controllable semiconductor switches can be used. The first and second legs are electrically connected in parallel between first and second DC rails. Each submodule 32₁, 32₂, ..., 32ₙ comprises three energy storage devices (i.e., capacitors) that are electrically connected in parallel with the series-connected semiconductor switches S₁ and S₂. The three capacitors form a capacitor assembly CA of the respective submodule. Although three capacitors are shown, it will be understood each capacitor assembly CA₁, CA₂, ..., CAₙ may have any suitable number of parallel-connected capacitors.

The semiconductor switches S₁ and S₂ of each submodule 30₁, 30₂, ..., 30ₙ and the semiconductor switches S₁, S₂, ..., S₄ of each submodule 32₁, 32₂, ..., 32ₙ are controlled by respective gate drive commands to be switched between an on-state and an off-state (i.e., switched on and off) to selectively charge, discharge or bypass the capacitor assemblies CA₁, CA₂, ..., CAₙ of the converter arm 28A or 28B.

Each submodule 30₁, 30₂, ..., 30ₙ and 32₁, 32₂, ..., 32ₙ comprises a voltage sensor 34 that is electrically connected in parallel with the respective capacitor assembly CA₁, CA₂, ..., CAₙ - i.e., in parallel with the individual capacitors. Each voltage sensor 34 provides a measurement of the voltage across the respective capacitor assembly. For example, the voltage sensor 34 of submodule 30₁ provides measurements v₁ of the voltage across the capacitor assembly CA₁ of submodule 30₁, the voltage sensor 34 of submodule 30₂ provides measurements v₂ of the voltage across the capacitor assembly CA₂ of submodule 30₂, and so on, until the voltage sensor 34 of submodule 30ₙ provides measurements vₙ of the voltage across the capacitor assembly CAₙ of submodule 30ₙ. Similarly, for example, the voltage sensor 34 of submodule 32₁ provides measurements v₁ of the voltage across the capacitor assembly CA₁ of submodule 32₁, the voltage sensor 34 of submodule 32₂ provides measurements v₂ of the voltage across the capacitor assembly CA₂ of submodule 32₂, and so on, until the voltage sensor 34 of submodule 32ₙ provides measurements vₙ of the voltage across the capacitor assembly CAₙ of submodule 32ₙ. It will be understood that this applies to all of the submodules in the MMC, i.e., to the submodules in all of the converter arms of the MMC. For example, for the MMC 1A shown in Figure 1, with six converter arms, if each converter arm has n submodules, there are a total of (6 x n) capacitor assemblies and the voltage sensors 34 of the respective submodules will simultaneously obtain (6 x n) individual DC voltage measurements - i.e., v₁, v₂, v₃, ..., v₍₆ₙ₋₁₎, v₆ₙ so that the voltage across each of the capacitor assemblies CA₁, CA₂, CA₃, ..., CA₍₆ₙ₋₁₎, CA₆ₙ of the MMC 1A is individually recorded. For the MMC 1B or 1C shown in Figures 2 and 3, respectively, with three converter arms, if each converter arm has n submodules, there are a total of (3 x n) capacitor assemblies and the voltage sensors of the respective submodules will simultaneously provide (3 x n) individual DC voltage measurements - i.e., v₁, v₂, v₃, ..., v₍₃ₙ₋₁₎, v₃ₙ so that the voltage across each of the capacitor assemblies CA₁, CA₂, CA₃, ..., CA₍₃ₙ₋₁₎, CA₃ₙ of the MMC 1A or 1B is individually recorded. For convenience in the following description, it may be assumed that the MMC whose condition is being monitored has a total of p submodules so that there is a total of p capacitor assemblies and the voltage sensors 34 of the respective submodules will simultaneously obtain p individual DC voltage measurements, where p is an integer (e.g., where p = 3n or 6n).

The individual DC voltage measurements obtained by the voltage sensors 34 may be provided to a controller 100 or remote server using any suitable protocol. The controller 100 or remote server will store or record the DC voltage measurements and carry out the processing described in more detail below for monitoring the condition of the capacitor assemblies of the MMC.

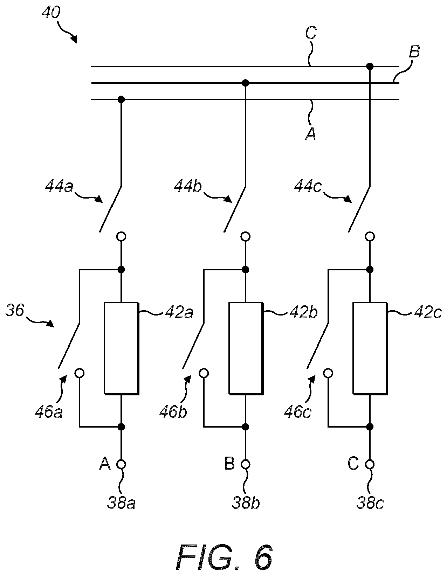

Figure 6 shows an example of a pre-charge circuit 36 that may be used to a pre-charge a MMC. The pre-charge circuit 36 includes three AC terminals 38a, 38b and 38c that define a respective AC phase (labelled "A", "B" and "C") and are electrically connected to the corresponding AC buses of the MMC. For example, the first AC terminal 38a is electrically connected to the first AC bus 12 of MMC 1A (or to the first AC bus 20 of MMC 1B or 1C), the second AC terminal 38b is electrically connected to the second AC bus 14 of MMC 1A (or to the second AC bus 22 of MMC 1B or 1C), and the third AC terminal 38c is electrically connected to the third AC bus 16 of MMC 1A (or to the third AC bus 24 of MMC 1B or 1C).

The first AC terminal 38a is electrically connected to the corresponding AC phase of a three-phase AC power grid 40 by a first pre-charge resistor 42a and a first switch 44a. The second AC terminal 38b is electrically connected to the corresponding AC phase of the power grid 40 by a second pre-charge resistor 42b and a second switch 44b. The third AC terminal 38c is electrically connected to the corresponding AC phase of the power grid 40 by a third pre-charge resistor 42c and a third switch 44c. The first, second and third switches 44a, 44b and 44c may be controlled to open and close by a controller (not shown). The power grid 40 may have a grid frequency of 50 Hz, for example.

Bypass switches 46a, 46b and 46c of the pre-charge circuit 36 may be closed to bypass the pre-charge resistors 42a, 42b and 42c. The bypass switches 46a, 46b and 46c may be closed during normal operation of the MMC - i.e., after the pre-charge process has ended and when the MMC is receiving power from the power grid 40 or supplying power to the power grid 40.

The health or condition of the capacitor assemblies of a MMC (e.g., the MMC 1A, 1B or 1C shown in Figures 1 to 3) can be monitored by obtaining DC voltage measurements during a pre-charge process where the individual capacitor assemblies are simultaneously charged to a rated voltage by an AC pre-charge current supplied to the AC buses (or AC terminals) of the MMC from the power grid 40 through the pre-charge circuit 36.

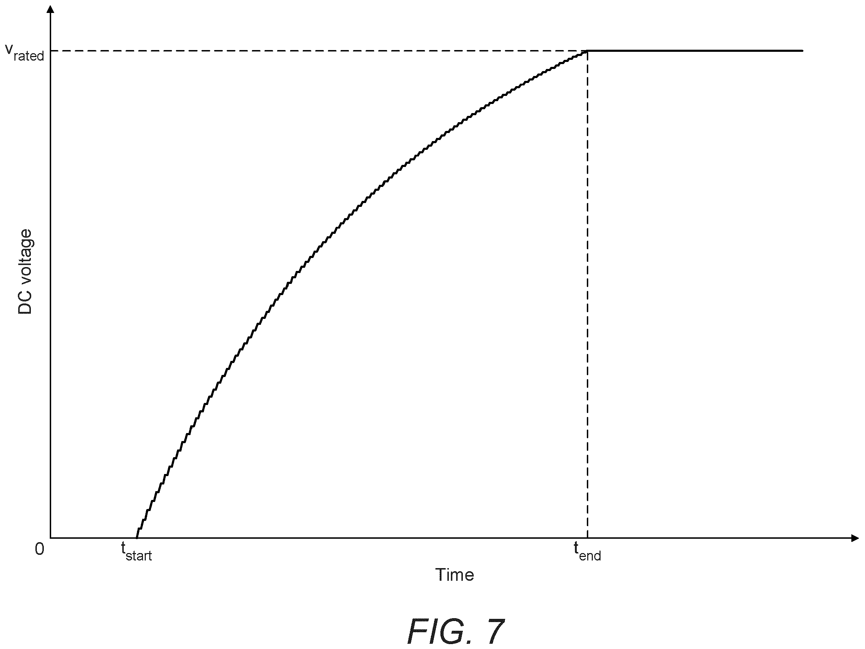

Figure 7 shows an example of how the DC voltage across the capacitor assembly of an individual submodule varies during a pre-charge process.

During the pre-charge process, the parallel-connected capacitors of the capacitor assembly are charged in a series of "steps" - i.e., periods of time when the DC voltage across the capacitor assembly increases (or "charging time periods") are alternated with periods of time when the DC voltage across the capacitor assembly remains substantially constant (or "non-charging time periods"). However, the overall shape of the DC voltage curve for the capacitor assembly during pre-charging is substantially exponential as shown in Figure 7. It will be readily understood that corresponding DC voltage curves can be shown for each capacitor assembly of the MMC - i.e., if there are p submodules and hence p capacitor assemblies (where p is an integer), there will be p DC voltage curves for the MMC. All of the DC voltage curves will have the same general exponential shape, but they will vary slightly because each capacitor assembly CA₁, CA₂, ..., CAₚ will have a slightly different capacitance and will therefore charge slightly differently during the pre-charge process.

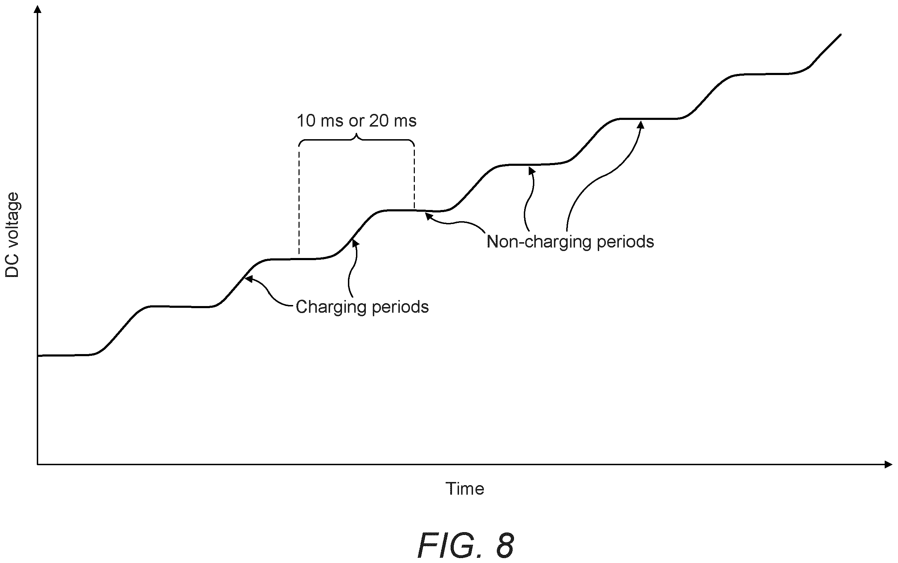

Each "step" (or "pulse") comprises a charging time period and a non-charging time period. The transitions between the "steps" (or "pulses") and between the charging and non-charging time periods are regular, well-defined, and will depend on the frequency of the AC pre-charge current that is supplied from the power grid 40 during the pre-charge process. For example, if the frequency of the supplied AC pre-charge current is 50 Hz, and the submodules of the MMC are implemented with a full-bridge topology, the duration of each "step" is 10 ms and the duration of each charging and non-charging time period is 5 ms. If the submodules are implemented with a half-bridge topology, the duration of each "step" is 20 ms and the duration of each charging and non-charging time period is 10 ms. The discrete "steps" are more clearly visible in Figure 8, which represents a relatively small part of the DC voltage curve of Figure 7.

It will be understood that the non-charging time periods are an ideal time for taking DC voltage measurements with minimum variability because the voltage across each capacitor assembly remains substantially constant.

The start of the pre-charge process (labelled "tₛₜₐᵣₜ" in Figure 7) may be determined by a close signal that controls the switches 44a, 44b and 44c of the pre-charge circuit 36 to close, or by measuring the pre-charge current, for example. For example, after the switches 44a, 44b and 44c have been controlled to close, the start of the pre-charge process may be determined by detecting the first peak of the pre-charge current that is supplied to the pre-charge circuit 36 from the power grid 40. The pre-charge circuit 36 may include one or more current sensors (not shown) for measuring the pre-charge current. Using a measurement of the pre-charge current may often be a more accurate way of determining the start of the pre-charge process than using the close signal or some other determination of when the switches 44a, 44b and 44c are closed, and may be particularly important if DC voltage measurements obtained during two or more pre-charge processes are to be compared for the purpose of condition monitoring. The end of the pre-charge process (labelled "t_{end}" in Figure 7) may be determined when the voltage across the capacitor assemblies has reached a pre-defined value for normal switching operation of the MMC (i.e., the rated voltage, which is labelled "v_{rated}" in Figure 7). The pre-charge process may typically be completed within a few seconds.

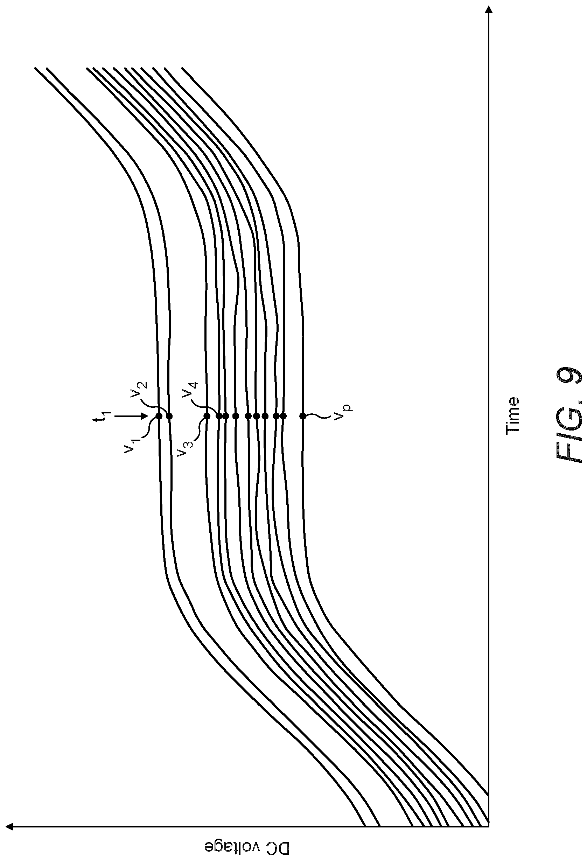

Figure 9 shows a discrete "step" of the DC voltage curves for a plurality of capacitor assemblies of the same MMC. Although only twelve DC voltage curves are shown in Figure 9 for improved clarity, it will be understood that in practice there will be significantly more DC voltage curves for a typical MMC. For example, if the MMC has at least 100 full bridge or at least 200 half-bridge submodules, there may be at least 100 or 200 individual DC voltage curves (e.g., p = 100 or 200). The start and end of each non-charging time period may be accurately determined based on the start time of the pre-charge process so that one or more DC voltage measurements may be obtained during a particular non-charging time period - e.g., at a predetermined time from the start time that coincides with a particular non-charging time period wherein the DC voltage across the capacitor assemblies remains substantially constant as shown in Figure 9. For example, a DC voltage measurement across each capacitor assembly may be obtained at time t₁ during the pre-charge process where t₁ coincides with a particular non-charging time period. Alternatively, two or more DC voltage measurements across each capacitor assembly may be obtained during a narrow time window that starts at time t₁ during the pre-charge process where the time window coincides with a particular non-charging time period so that all of the measurements are obtained with minimum variability and where the two or more DC voltage measurements are used to determine an average voltage. This may improve the reliability of the DC voltage measurements obtained during the pre-charge process.

In Figure 9, the time t₁ at which the DC voltage measurements are obtained is shown to be about in the centre of the particular non-charging time period. A first DC voltage measurement (e.g., v₁) is obtained for the capacitor assembly of a first submodule at time t₁, a second DC voltage measurement (e.g., v₂) is obtained for the capacitor assembly of a second submodule at time t₁, a third DC voltage measurement (e.g., v₃) is obtained for the capacitor assembly of a third submodule at time t₁, and so on, until a pth voltage measurement (e.g., vₚ) is obtained for the capacitor assembly of a pth submodule at time t₁.

At the end of a particular pre-charge process, an individual DC voltage measurement (i.e., v₁, v₂, v₃, ..., vₚ) will have been obtained for the capacitor assembly of each submodule at time t₁. Additional individual DC voltage measurements may also be obtained for the capacitor assembly of each submodule at other times during the pre-charge process, e.g., at times t₂, t₃ etc. that are not shown but which may be before or after time t₁. Each time t₂, t₃ etc. may coincide with a different non-charging time period.

The DC voltage measurements are preferably stored, e.g., in a memory. The stored DC voltage measurements are then processed to determine a condition of each capacitor assembly. The DC voltage measurements may be processed by the controller 100 or may be sent to a remote server for processing. The processing does not need to be carried out in "real time" but may be done after the pre-charge process has ended and the MMC has started its normal operation.

Condition monitoring may be carried out using the DC voltage measurements obtained from a single pre-charge process. For example, the DC voltage measurements obtained for each capacitor assembly at a particular time (e.g., time t₁) may be compared. As shown in Figure 9, if there are p submodules and hence p capacitor assemblies (where p is an integer), the DC voltage measurements v₁, v₂, v₃, v₄, ..., vₚ obtained at the same time (e.g., time t₁) during the pre-charge process, may be compared. The measurement timing is determined with reference to the start time of the pre-charge process. This ensures that the DC voltage measurements v₁, v₂, v₃, v₄, ..., vₚ for all of the submodules are obtained at the same time by the respective voltage sensor 34. In one example, the DC voltage measurements v₁, v₂, v₃, v₄, ..., vₚ obtained at time t₁ may be compared against an expected voltage for the time t₁. If an individual DC voltage measurement deviates from the expected voltage by more than a pre-defined amount (e.g., by more than ± *x*%) this may indicate that at least one of the capacitors of the particular capacitor assembly is not in best condition and further testing may be carried out. This may also be repeated for any DC voltage measurements obtained at other times during the pre-charge process, e.g., at times t₂, t₃ etc.

In another example, the DC voltage measurements v₁, v₂, v₃, v₄, ..., vₚ obtained at time t₁ may be used to determine an average voltage for the time t₁. If an individual DC voltage measurement deviates from the average voltage by more than a pre-defined amount (e.g., by more than ± x%) this may indicate that at least one of the capacitors of the particular capacitor assembly is not in best condition and further testing may be carried out. This may also be repeated for any DC voltage measurements obtained at other times during the pre-charge process, e.g., at times t₂, t₃ etc.

Because of manufacturing tolerances, it may be expected that the measured DC voltages of different capacitor assemblies will vary by up to a few percent even though the individual capacitors have exactly the same design and nominal capacitance value. Condition monitoring may here be as simple as categorising any capacitor assemblies whose DC voltage measurements deviate from the expected or average voltage by less than the predefined amount as having an acceptable condition, and categorising any remaining capacitor assemblies as requiring further testing or monitoring, for example. Alternatively, the condition monitoring may depend on the amount by which the individual DC voltage measurement deviates from the expected or average voltage, or may use two or more pre-defined amounts that relate to different deviations from the average or expected voltage. For example, if the individual DC voltage measurement deviates from the average or expected voltage by more than a first pre-defined amount (e.g., by more than ± x7%) but by less than or equal to a second pre-defined amount (e.g., by less than or equal to ± x2% where x2 is greater than *x1*) this may indicate that at least one of the capacitors of the particular capacitor assembly is not in best condition and further testing may be carried out. However, if the individual DC voltage measurement deviates from the average or expected voltage by more than the second pre-defined amount (e.g., by more than ±*x2*%), this may indicate that more urgent action is needed, including potentially replacing one or more of the capacitors of the particular capacitor assembly. Condition monitoring may be based on any suitable number of pre-defined amounts that allow the deviation of an individual DC voltage measurement of a particular capacitor assembly from the expected or average voltage to be categorised and if necessary for an appropriate action to be taken depending on the indicated degradation.

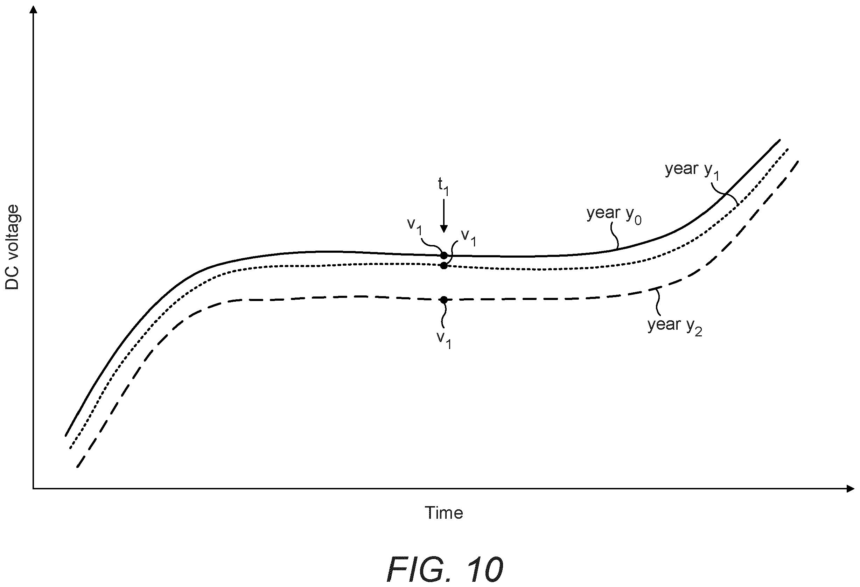

It is generally preferred that the condition monitoring uses DC voltage measurements obtained from two or more pre-charge processes. For example, an initial pre-charge process may be carried out to establish a "baseline" for the condition of the capacitor assemblies. The initial pre-charge process for establishing the "baseline" may be carried out during first commissioning of the MMC. The same pre-charge process may then be carried out at intervals, for example every six months, every year, or every two or three years, as part of a regular maintenance program for the MMC, so that the condition of the capacitor assemblies may be monitored regularly for degradation. For example, if the same pre-charge process has been carried out three times, with an initial pre-charge process being carried out in year y₀, a second pre-charge process being carried out a year later in year y₁, and a third pre-charge process being carried out a further year later in year y₂, stored DC voltage measurements for each pre-charge process may be used to determine the condition of each capacitor assembly. The same pre-charge circuit 36 is used for each pre-charge process, i.e., with the same pre-charge resistors 42a, 42b and 42c. Figure 10 shows a discrete "step" with DC voltage curves for the same capacitor assembly of the MMC obtained in years y₀, y₁ and y₂. A DC voltage measurement v₁ obtained at time t₁ in year y₁ may be compared against the DC voltage measurement v₁ obtained at time t₁ in year y₀ (e.g., when the MMC was first commissioned). The DC voltage measurement v₁ obtained at time t₁ in year y₂ may also be compared against the DC voltage measurement v₁ obtained at time t₁ in year y₀. DC voltage measurements obtained at other times (e.g., times t₂, t₃ etc.) during each pre-charge process may also compared in a similar manner.

A similar comparison can be carried out for the DC voltage measurements obtained for the other capacitor assemblies.

The time (or times) when the DC voltage measurements are obtained will be the same for each pre-charge process, and each time is determined based on the start time of the respective pre-charge process. This allows the DC voltage measurements obtained for each individual capacitor assembly at the same time during each pre-charge process (e.g., each year) to be compared directly. Changes in the DC voltage measurements that may indicate the degradation of a particular capacitor assembly of the MMC may therefore be identified. For example, Figure 10 shows that there is a general decrease in the measured DC voltage across the capacitor assembly over time which indicates that the capacitor assembly is degrading at a particular rate.

Alternatively, the DC voltage measurements obtained for each capacitor assembly may be used to determine a characteristic of each capacitor assembly, which characteristic may then be used to determine the condition of each capacitor assembly. The characteristic may be a time constant of each capacitor assembly - e.g., the time taken for each capacitor assembly to charge to 63.2% of its rated voltage. The time constant of each capacitor assembly is known to be equal to the capacitance of the capacitor assembly multiplied by the total resistance of the pre-charge circuit 36. Consequently, any change in the time constant determined in different pre-charge processes is indicative of a change in the capacitance of the particular capacitor assembly. The total resistance of the pre-charge circuit 36 is the same for all capacitor assemblies charged at the same time. For example, for a particular capacitor assembly, the time constant τ₁ determined in year y₁ may be compared against the time constant τ₁ determined in year y₀ (e.g., when the MMC was first commissioned). The time constant τ₁ determined in year y₂ may also be compared against the time constant τ₁ determined in year y₀.

Any change in the DC voltage measured across a particular capacitor assembly at the same time in different pre-charge processes (or any change in the determined time constant of a particular capacitor assembly) is indicative of a change in the capacitance of the capacitor assembly. It is important to note that it is not necessary to determine the absolute capacitance of the capacitor assemblies of the MMC because this would also require knowing other electrical parameters such as the absolute value of the total resistance of the pre-charge circuit 36, for example. In the above example, if comparison of the respective DC voltage measurements v₁ obtained in years y₁ and y₀ indicates that the DC voltage has decreased by 1% this may be considered to be indicative that the capacitance of the capacitor assembly of a particular submodule has decreased by 1% over the course of the year. This may not require immediate action, but if the capacitance continues to decrease it may exceed permitted tolerances and the capacitor assembly may be scheduled for replacement at a suitable point in the future. Further testing may also be carried out to try and identify if only certain of the capacitors of the capacitor assembly are affected. This may avoid the need to replace all of the capacitors of the particular submodule. The method may indicate if the capacitance of a particular capacitor assembly has decreased by more than a threshold amount, where the threshold amount may optionally be determined based on an expected degradation rate of the capacitors utilised in the MMC and the period of time between the respective pre-charge processes. As noted above, the measured DC voltages are indicative of the capacitance. For example, the expected degradation rate in the capacitance of the capacitors may be 0.5% per year. A decrease of 0.8% in the capacitance (as indicated by the measured DC voltage across a particular capacitor assembly) would therefore not exceed the threshold amount if the period of time between the respective pre-charge processes was two years, for example. This is because the decrease in the capacitance would only be 0.4% per year. But if the respective pre-charge processes are only one year apart, the threshold amount would be exceeded. This is because the decrease in the capacitance would be 0.8% per year.

It will be understood that there may be some variation in electrical parameters when the pre-charge process is carried out at different times, e.g., each year. Although the same pre-charge circuit 36 with the same pre-charge resistors 42a, 42b and 42c will be used for each pre-charging of the MMC, there may still be some variation in the absolute value of the total resistance of the pre-charge circuit 36 as a result of differences in ambient temperature, for example. There may also be some variation in the AC pre-charge current supplied by the power grid 40. However, such variations may be considered to affect the DC voltage measurements for each capacitor assembly in the same way and can therefore be corrected or compensated for using a suitable calibration or compensation process. For example, because the total resistance of the pre-charge circuit 36 is the same for all capacitor assemblies charged at the same time, any variation in the total resistance when each pre-charge process is carried out will have the same effect on the DC voltages measured across all of the capacitor assemblies. In other words, the disturbances to be eliminated by the calibration or compensation process are "common mode" disturbances. A calibration or compensation process may be carried out on the stored DC voltage measurements obtained during a pre-charge process before any comparison is made with the stored DC voltage measurements obtained during a previous pre-charge process. Any suitable calibration or compensation process may be used.

The calibrated or compensated DC voltage measurements obtained after carrying out the calibration or compensation process may also be stored and may then be used in any comparison made with DC voltage measurements obtained in a subsequent pre-charge process.

## Claims

1. A method of monitoring the condition of energy storage device assemblies of a modular multi-level converter MMC (1A; 1B; 1C), the MMC (1A; 1B; 1C) comprising a plurality of series-connected submodules (30₁, 30₂, ..., 30ₙ; 32₁, 32₂, ..., 32ₙ), each submodule comprising a plurality of semiconductor devices, each semiconductor device including at least a controllable semiconductor switch (S₁, S₂; S₁, S₂, ..., S₄), and an energy storage device assembly (CA₁, CA₂, ..., CAₙ) including one or more individual energy storage devices electrically connected in parallel, the MMC (1A; 1B; 1C) further comprising at least one alternating current AC terminal electrically connectable to an AC power source (40), the method comprising:
during a pre-charge process where the individual energy storage device assemblies (CA₁, CA₂, ..., CAₙ) of the MMC (1A; 1B; 1C) are initially charged to a rated voltage by an AC pre-charge current supplied to the at least one AC terminal from the AC power source (40), obtaining one or more measurements of the direct current DC voltage across each energy storage device assembly (CA₁, CA₂, ..., CAₙ) at one or more times between a start of the pre-charge process and an end of the pre-charge process; and
using the one or more DC voltage measurements obtained during the pre-charge process to determine the condition of each energy storage device assembly (CA₁, CA₂, ..., CAₙ).

2. A method according to claim 1, wherein the one or more DC voltage measurements are obtained for each energy storage device assembly (CA₁, CA₂, ..., CAₙ) during one or more of non-charging time periods where the voltage across each energy storage device assembly (CA₁, CA₂, ..., CAₙ) is substantially constant.

3. A method according to claim 2, wherein two or more DC voltage measurements are obtained for each energy storage device assembly (CA₁, CA₂, ..., CAₙ) during a non-charging time period and where an average value of the DC voltage is determined for the non-charging time period.

4. A method according to any preceding claim, wherein the start of the pre-charge process is determined by measuring the AC pre-charge current.

5. A method according to any preceding claim, further comprising:
during a second pre-charge process where the individual energy storage device assemblies (CA₁, CA₂, ..., CAₙ) of the MMC (1A; 1B; 1C) are initially charged to a rated voltage by an AC pre-charge current supplied to the at least one AC terminal from the AC power source (40), obtaining one or more measurements of the DC voltage across each energy storage device assembly (CA₁, CA₂, ..., CAₙ) at one or more times between a start of the second pre-charge process and an end of the second pre-charge process; and
using the one or more DC voltage measurements obtained during the pre-charge process and the one or more DC voltage measurements obtained during the second pre-charge process to determine the condition of each energy storage device assembly (CA₁, CA₂, ..., CAₙ).

6. A method according to claim 5, further comprising indicating if the capacitance of a particular energy storage device assembly (CA₁, CA₂, ..., CAₙ) has decreased by more than a threshold amount.

7. A method according to claim 6, wherein the threshold amount is determined based on an expected degradation rate of the energy storage devices and the period of time between the first and second pre-charge processes.

8. A method according to any of claims 5 to 7, further comprising carrying out a calibration or compensation process on the DC voltage measurements obtained during the second pre-charge process.

9. A MMC (1A; 1B; 1C) comprising:
a plurality of series-connected submodules (30₁, 30₂, ..., 30ₙ; 32₁, 32₂, ..., 32ₙ), each submodule comprising:
a plurality of semiconductor devices, each semiconductor device including at least a controllable semiconductor switch (S₁, S₂; S₁, S₂, ..., S₄), and
an energy storage device assembly (CA₁, CA₂, ..., CAₙ) including one or more individual energy storage devices electrically connected in parallel;
at least one AC terminal electrically connectable to an AC power source (40); and
a condition monitoring device adapted to:
obtain one or more measurements of the DC voltage across each energy storage device assembly (CA₁, CA₂, ..., CAₙ) at one or more times between a start of a pre-charge process and an end of the pre-charge process, wherein during the pre-charge process the individual energy storage device assemblies (CA₁, CA₂, ..., CAₙ) of the MMC (1A; 1B; 1C) are initially charged to a rated voltage by an AC pre-charge current supplied to the at least one AC terminal from the AC power source; and
use the one or more DC voltage measurements to determine the condition of each energy storage device assembly (CA₁, CA₂, ..., CAₙ).

10. A MMC (1A; 1B; 1C) according to claim 9, wherein the condition monitoring device is further adapted to:
obtain one or more measurements of the DC voltage across each energy storage device assembly (CA₁, CA₂, ..., CAₙ) at one or more times between a start of a second pre-charge process and an end of the second pre-charge process, wherein during the second pre-charge process the individual energy storage device assemblies (CA₁, CA₂, ..., CAₙ) of the MMC (1A; 1B; 1C) are initially charged to a rated voltage by an AC pre-charge current supplied to the at least one AC terminal from the AC power source (40); and
use the one or more DC voltage measurements obtained during the pre-charge process and the one or more DC voltage measurements obtained during the second pre-charge process to determine the condition of each energy storage device assembly (CA₁, CA₂, ..., CAₙ).

11. A MMC (1A; 1B; 1C) according to claim 9 or claim 10, wherein each semiconductor device further includes an anti-parallel connected diode (D₁, D₂; D₁, D₂, ..., D₄).

12. A MMC (1A; 1B; 1C) according to any of claims 9 to 11, wherein the plurality of series-connected submodules (30₁, 30₂, ..., 30ₙ; 32₁, 32₂, ..., 32ₙ) define a converter arm of the MMC (1A; 1B; 1C), wherein the converter arm further comprises at least one inductor.

13. A MMC (1A; 1B; 1C) according to any of claims 9 to 12, wherein each submodule (30₁, 30₂, ..., 30ₙ) has a full-bridge topology or wherein each submodule (32₁, 32₂, ..., 32ₙ) has a half-bridge topology.

14. A MMC (1A; 1B; 1C) according to any of claims 9 to 13, wherein each submodule (30₁, 30₂, ..., 30ₙ; 32₁, 32₂, ..., 32ₙ) includes a DC voltage measurement unit (34).

15. A MMC (1A; 1B; 1C) according to any of claims 9 to 14, further comprising a pre-charge circuit (36) including at least one pre-charge resistor (42a, 42b, 42c) and at least one switch (44a, 44b, 44c), wherein the at least one AC terminal of the MMC is electrically connected to the pre-charge circuit (36) and the pre-charge circuit is electrically connectable to the AC power source (40).
